# EUROPÄISCHE PATENTANMELDUNG

(11) **EP 4 047 380 A1**
(43) Veröffentlichungstag der Anmeldung: **24.08.2022**
(21) Anmeldenummer: 21157921.4
(22) Anmeldetag: 18.02.2021
(51) Int. Cl.: G01R 31/36, H02J 7/00

(54) **VERFAHREN UND SYSTEM ZUR ANALYSE EINES ELEKTRISCHEN ENERGIESPEICHERS SOWIE ENERGIEVERSORGUNGSSYSTEM**

(71) Anmelder: FRONIUS INTERNATIONAL GmbH, 4643 Pettenbach (AT)
(72) Erfinder: GUSCHLBAUER, Florian, 4643 Pettenbach (AT); HEIGL, Hannes, 4643 Pettenbach (AT); MÜHLEGGER, Johannes, 4643 Pettenbach (AT); PFAFFENBICHLER, Dominik, 4643 Pettenbach (AT)
(74) Vertreter: SONN Patentanwälte OG

(57) **Zusammenfassung**

Die Erfindung betrifft ein Verfahren zur Analyse eines elektrischen Energiespeichers (2), insbesondere eines Akkumulators oder einer Batterie, wobei der Energiespeicher (2) in ein elektrisches Energieversorgungssystem (1) mit zumindest einem Verbraucher (4) und zumindest einer elektrischen Energiequelle (5) elektrisch verbunden ist, wobei ein elektrischer Energiefluss (F) in den oder aus dem Energiespeicher (2) gemessen wird und iterativ auf Basis erfasster Werte des gemessenen Energieflusses (F) zumindest ein Parameter (P) des Energiespeichers (2) bestimmt wird.

Des Weiteren betrifft die Erfindung ein elektrisches Analysesystem (21) und ein Energieversorgungssystem (1).

## Beschreibung

Die Erfindung betrifft ein Verfahren zur Analyse eines elektrischen Energiespeichers, insbesondere eines Akkumulators oder einer Batterie, wobei der Energiespeicher in einem elektrischen Energieversorgungssystem mit zumindest einem Verbraucher und zumindest einer elektrischen Energiequelle elektrisch verbunden ist.

Des Weiteren betrifft die Erfindung ein elektrisches System zur Analyse eines elektrischen Energiespeichers und ein elektrisches Energieversorgungssystem mit einem solchen Analysesystem.

Elektrische Energieversorgungssysteme, beispielsweise für Haushalte oder Gewerbebetriebe, bestehen in der Regel aus mehreren Komponenten, unter anderem einem elektrischen Energiespeicher, einem Wechselrichter und einer Steuerungseinheit zur Aufteilung der Lastflüsse ("Energiemanagementeinheit"). Zusätzlich können auch noch Energiequellen, wie zum Beispiel Photovoltaikanlagen, in das Energieversorgungssystem eingebunden sein. Auf dem Markt existiert eine Vielzahl von Herstellern von Komponenten für Energieversorgungssysteme. Meist werden bei Energieversorgungssystemen ausschließlich Komponenten des gleichen Herstellers eingesetzt, da diese aufeinander abgestimmt und miteinander kompatibel sind. Es ist aber auch prinzipiell möglich und in manchen Fällen sogar wünschenswert, in einem Energieversorgungssystem Komponenten von unterschiedlichen Herstellern miteinander zu kombinieren. Manche Komponenten von Energieversorgungssystemen benötigen jedoch zur korrekten Funktionsweise einen Datenaustausch mit anderen Komponenten des Energieversorgungssystems. Beispielsweise soll die Steuerungseinheit einen momentanen Ladezustand und andere Parameter des Energiespeichers abfragen können, sodass die Steuerungseinheit die Lastflüsse im Energieversorgungssystem an den Betriebszustand des Energiespeichers anpassen kann bzw. der Energiespeicher in ein bestehendes Energiekonzept bzw. Energiemanagement eingebunden werden kann. Viele Komponenten für Energieversorgungssysteme erlauben jedoch nur einen Datenaustausch mit Komponenten des gleichen Herstellers. Ein Datenaustausch zwischen Komponenten verschiedener Hersteller ist oft gar nicht oder nur mit zusätzlichem Aufwand möglich. Es wäre jedoch wünschenswert, in einem Energieversorgungssystem Komponenten verschiedenster Hersteller ohne zusätzlichen Aufwand und ohne Einschränkung der Funktionsweise kombinieren zu können. Insbesondere wäre es wünschenswert, wenn andere Komponenten eines Energieversorgungssystems Kenntnis über den Betriebszustand eines Energiespeichers erlangen könnten, ohne dass ein Datenaustausch mit dem Energiespeicher stattfinden muss. Auf diese Weise könnte ein Energiespeicher eines Herstellers in ein Energieversorgungssystem mit Komponenten eines anderen Herstellers auf einfache Weise integriert werden, ohne dass die Funktionsweise des Energieversorgungssystems beeinträchtigt würde.

Aus dem Stand der Technik, beispielsweise aus der WO 2018/104948 A1 und der US 2019/0056451 A1, sind Energiespeicher bzw. Verfahren zur Bestimmung von Parametern von Energiespeichern bekannt.

Im Lichte der obigen Ausführungen ist es Aufgabe der vorliegenden Erfindung, die Nachteile des Standes der Technik zu lindern oder gar gänzlich zu beseitigen. Insbesondere ist es Aufgabe der vorliegenden Erfindung, ein Verfahren und ein System zur Analyse eines Energiespeichers zur Verfügung zu stellen, mit denen zumindest ein Parameter eines in ein Energieversorgungssystem integrierten Energiespeichers bestimmt werden kann, ohne dass ein Datenaustausch mit dem Energiespeicher erforderlich ist.

Gelöst wird diese Aufgabe zunächst durch ein Verfahren nach Anspruch 1. Demnach ist erfindungsgemäß bei einem Verfahren der eingangs erwähnten Art vorgesehen, dass ein Energiefluss in den oder aus dem Energiespeicher gemessen wird und iterativ auf Basis erfasster Werte des gemessenen Energieflusses zumindest ein Parameter des Energiespeichers bestimmt wird. Vorteilhafterweise ist durch das erfindungsgemäße Verfahren kein Datenaustausch mit dem Energiespeicher bzw. dessen Steuerungseinheit mehr notwendig, um zum Beispiel Informationen über den Ladezustand oder die Nutzkapazität des Energiespeichers zu erlangen. Der Wert des zumindest einen mit dem Verfahren bestimmten Parameters kann vor Beginn des Verfahrens unbekannt sein. Zur Bestimmung des zumindest einen Parameters des Energiespeichers wird der elektrische Energiefluss in den oder aus dem Energiespeicher gemessen, gespeichert und ausgewertet. Als Basis zur Messung des Energieflusses können zumindest die Messwerte von Strom und Spannung dienen. Die Messung des Energieflusses kann beispielsweise durch ein oder mehrere Wattmeter oder ein oder mehrere Smart Meter erfolgen. Der Energiefluss ist eine Leistungsgröße und besitzt die Einheit Energie pro Zeit, insbesondere Watt oder Joule pro Sekunde. Auf Basis des Energieflusses in oder aus dem Energiespeicher kann zumindest ein Parameter des Energiespeichers bestimmt werden, der insbesondere zuvor unbekannt war oder auf welchen aus den oben erläuterten Gründen kein Zugriff bestand. Durch Kenntnis des zumindest einen Parameters kann der Energiespeicher effizienter gesteuert und beispielsweise besser in ein bestehendes Energiekonzept eingebunden werden. Die Anwendung des Verfahrens ist insbesondere vorteilhaft, wenn ein fremder Energiespeicher eines Herstellers in ein Energieversorgungssystem mit Komponenten eines anderen Herstellers integriert werden soll. Wie eingangs ausgeführt, ist in solchen Fällen meist kein Zugriff auf die Parameter des Energiespeichers möglich, da viele Energiespeicher keinen Datenaustausch mit Komponenten anderer Hersteller erlauben. Der gemessene Energiefluss stellt - je nach Richtung - zu jedem Zeitpunkt eine Momentaufnahme der Leistungsaufnahme oder der Leistungsabgabe des Energiespeichers dar. Vorzugsweise kann durch ständige Messung des Energieflusses und unter Berücksichtigung bisher gemessener Werte des Energieflusses der zumindest eine Parameter des Energiespeichers bestimmt und laufend angepasst werden. In einer Ausführungsform können in einer Lernphase zu Beginn der Anwendung des Verfahrens, bevor der zumindest eine Parameter bestimmt oder endgültig bestimmt wird, die gemessenen Werte des Energieflusses über einen Zeitraum, beispielsweise zumindest eine oder mehrere Stunden, aufgezeichnet und abgespeichert werden. In dieser Lernphase kann auch eine angeschlossene Last aktiviert oder deaktiviert werden, um den Energiespeicher zum Laden bzw. Entladen "anzuregen". Der zumindest eine Parameter kann dann anschließend an die Lernphase auf Basis der abgespeicherten Werte bestimmt werden. Der zumindest eine Parameter kann selbstverständlich auch nach Abschluss der Lernphase auf Basis weiterer gemessener Werte des Energieflusses laufend angepasst oder neu bestimmt werden. Die ständige Ermittlung des Energieflusses kann zeitdiskret, d.h. in zeitlich regelmäßigen oder auch unregelmäßigen Abständen, erfolgen. Aus den gemessenen Werten des Energieflusses kann ein zeitlicher Verlauf, auch Energieverlauf bezeichnet, der in den Energiespeicher fließenden und aus dem Energiespeicher entnommenen Energie ermittelt werden. Der Energieverlauf kann aus dem Energiefluss insbesondere durch dessen zeitliche Integration ermittelt werden. Der Energieverlauf wird vorzugsweise gespeichert, sodass zu jedem vergangenen Zeitpunkt ein entsprechender Wert der Energie zur Verfügung steht. In einer Ausführungsform kann auf Basis dieses zeitlichen Verlaufs der zumindest eine Parameter bestimmt werden. Bei dem zumindest einen Parameter kann es sich beispielsweise um eine momentan im Energiespeicher enthaltene Energie, eine momentan mindestens verfügbare Kapazität des Energiespeichers, insbesondere eine momentan mindestens verfügbare Lade- oder Entladekapazität, eine Nutzkapazität des Energiespeichers, einen Ladezustand des Energiespeichers, einen Eigenverbrauch des Energiespeichers, einen Lade- und Entladeverlust des Energiespeichers, einen Wirkungsgrad, einen Energiespeichermodellparameter oder einen Parameter einer Lade- oder Entladecharakteristik des Energiespeichers handeln. Unter Lade- oder Entladecharakteristik sind unter anderem die Ladeleistung und die Entladeleistung umfasst.

Es können mit dem erfindungsgemäßen Verfahren selbstverständlich auch mehrere der genannten Parameter bestimmt werden. Eine momentan mindestens verfügbare Kapazität des Energiespeichers ist eine Energiemenge, die zu einem bestimmten Zeitpunkt für Lade- oder Entladezwecke des Energiespeichers mindestens zur Verfügung steht. Die mindestens verfügbare Kapazität kann demnach, je nach Anwendung, eine Energiemenge sein, die mindestens in den Energiespeicher geladen oder diesem entnommen werden kann. Die mindestens verfügbare Kapazität kann demnach eine Ladekapazität oder eine Entladekapazität des Energiespeichers sein. Die Nutzkapazität eines Energiespeichers ist die maximale Energiemenge eines Energiespeichers, die auch tatsächlich zu Lade- und Entladezwecken genutzt werden kann. Die Nutzkapazität ist in der Regel geringer als die Nennkapazität des Energiespeichers, da nicht die gesamte Nennkapazität eines Energiespeichers genutzt werden kann. Die Nutzkapazität entspricht Summe aus Ladekapazität und Entladekapazität. Der Ladezustand des Energiespeichers, auch als SoC ("State of Charge") bezeichnet, kann z.B. in Prozent angegeben werden und stellt die momentan im Energiespeicher enthaltene Energiemenge bezogen auf dessen Nutzkapazität dar. Der zumindest eine Parameter, der bestimmt wird, muss nicht über die Zeit konstant sein, sondern kann auch variieren, wie etwa der Ladezustand. Der zumindest eine Parameter wird daher iterativ bestimmt. Iterativ bedeutet, dass der zumindest eine Parameter laufend neu bestimmt oder angepasst wird, und zwar auf Basis bisher erfasster und neu gemessener Werte des Energieflusses. Beispielsweise kann vorgesehen sein, dass nach jeder neuen Messung des Energieflusses der zumindest eine Parameter angepasst oder neu bestimmt wird. Die Messungen können, wie bereits erwähnt, zeitdiskret erfolgen, beispielsweise alle 1 bis 10 Sekunden. Natürlich sind auch kürzere oder längere Intervalle möglich. Durch die iterative Bestimmung des zumindest einen Parameters kann der durch das Verfahren bestimmte Wert des Parameters dem tatsächlichen Wert des Parameters im Laufe der Zeit angenähert werden. Der Energiespeicher kann aus mehreren Zellen oder Sub-Energiespeicher bestehen und beispielsweise auch einen integrierten Wechselrichter aufweisen.

In einer bevorzugten Ausführungsform der Erfindung ist vorgesehen, dass auf Basis erfasster Werte des Energieflusses eine Nutzkapazität des Energiespeichers als Parameter bestimmt wird. Vorzugsweise wird aus den gemessenen Werten des Energieflusses ein zeitlicher Verlauf der in den Energiespeicher fließenden und aus dem Energiespeicher entnommenen Energie ermittelt, beispielsweise durch zeitliche Integration des Energieflusses. Dieser zeitliche Verlauf kann, wie oben bereits ausgeführt, auch als Energieverlauf bezeichnet werden. Aus dem Energieverlauf können ein vorzugsweise globales Minimum und ein vorzugsweise globales Maximum bestimmt werden. Durch Differenzbildung zwischen dem vorzugsweise globalen Maximum und dem vorzugsweise globalen Minimum kann die Nutzkapazität des Energiespeichers bestimmt werden. Die Maxima und Minima des Energieverlaufs können sich im Laufe der Zeit ändern. Dementsprechend können auch diese iterativ bestimmt werden und die Nutzkapazität des Energiespeichers entsprechend angepasst bzw. neu bestimmt werden. Je länger das Verfahren angewandt wird, desto höher ist die Wahrscheinlichkeit, dass sich die globalen Maxima und Minima nicht mehr ändern und die ermittelte Nutzkapazität der tatsächlichen Nutzkapazität angenähert ist. Aus diesem Grund kann, wie oben bereits erwähnt, vorzugsweise eine Lernphase vorgesehen sein, in welcher der Energiefluss in den oder aus dem Energiespeicher aufgezeichnet wird. Die Lernphase kann beispielsweise für eine festgelegte Zeitdauer durchgeführt werden. Die Lernphase kann auch so lange dauern, bis sich das globale Maximum und das globale Minimum des Energieverlaufs für einen vorgegebenen Beobachtungszeitraum nicht mehr ändern. Das globale Maximum und das globale Minimum werden in der Lernphase laufend angepasst. Anfänglich entspricht das (einzige) Maximum dem globalen Maximum. Dieses wird gespeichert und falls ein neues Maximum das globale Maximum überschreitet, wird das globale Maximum gemäß diesem neuen Wert neu festgelegt. Gleiches gilt für das globale Minimum. Nach Beendigung der Lernphase steht das globale Maximum und das globale Minimum und damit die Nutzkapazität fest. Das Verfahren selbst kann jedoch nach Beendigung der Lernphase fortgesetzt werden, da sich andere Parameter, wie beispielsweise der Ladezustand des Energiespeichers, ändern können. Diese Änderungen werden durch das Verfahren erfasst.

In einer weiteren Ausführungsform der Erfindung wird auf Basis erfasster Werte des Energieflusses als Parameter eine momentan in dem Energiespeicher enthaltene Energie bestimmt. Die momentan im Energiespeicher enthaltene Energie kann, wie der Energieverlauf im Allgemeinen, beispielsweise durch zeitliche Integration des gemessenen Energieflusses in den oder aus dem Energiespeicher bestimmt werden. Es versteht sich von selbst, dass die Integration eines Anfangswerts bedarf, der beispielsweise zunächst bei Null liegen kann. Anschaulich gesprochen kann bei dieser Ausführungsform vorgesehen sein, dass der Energieverlauf, also der zeitliche Verlauf der in den Energiespeicher fließenden und aus dem Energiespeicher entnommenen Energie, bestimmt wird. Ein zeitlicher Endpunkt dieses Energieverlaufs stellt die momentan im Energiespeicher zur Verfügung stehende Energie dar, wobei der Endpunkt durch neu gemessene Werte des Energieflusses ständig verändert wird und zeitlich fortschreitet.

In einer bevorzugten Ausführungsform der Erfindung werden zumindest eine Nutzkapazität und eine momentan im Energiespeicher enthaltene Energie bestimmt.

In einer Ausführungsform der Erfindung kann vorgesehen sein, dass auf Basis der momentan in dem Energiespeicher enthaltenen Energie und der Nutzkapazität des Energiespeichers ein momentaner Ladezustand des Energiespeichers bestimmt wird. Der momentane Ladezustand des Energiespeichers kann bestimmt werden, indem die momentan im Energiespeicher enthaltene Energie in ein Verhältnis zur Nutzkapazität gesetzt wird.

In einer weiteren Ausführungsform der Erfindung wird auf Basis erfasster Werte des Energieflusses als Parameter eine momentan mindestens verfügbare Kapazität des Energiespeichers bestimmt. Die mindestens verfügbare Kapazität kann eine mindestens verfügbare Ladekapazität oder eine mindestens verfügbare Entladekapazität sein. Aus dem oben beschriebenen Energieverlauf können ein vorzugsweise globales Minimum und/oder ein vorzugsweise globales Maximum bestimmt werden. Eine Differenz zwischen dem vorzugsweise globalen Minimum und der momentan im Energiespeicher enthaltenen Energie stellt eine momentan mindestens verfügbare Entladekapazität des Energiespeichers dar. Eine Differenz zwischen dem vorzugsweise globalen Maximum und der momentan im Energiespeicher enthaltenen Energie stellt eine momentan mindestens verfügbare Ladekapazität des Energiespeichers dar. Eine Entladekapazität bezeichnet eine Energiemenge, die dem Energiespeicher entnommen werden kann. Eine Ladekapazität bezeichnet eine Energiemenge, die in den Energiespeicher geladen werden kann.

Vorzugsweise wird zur Messung des Energieflusses in oder aus dem Energiespeicher ein elektrischer Strom in und aus dem Energiespeicher sowie eine elektrische Spannung am Energiespeicher gemessen. Das Produkt aus gemessenem Strom und gemessener Spannung zu einem bestimmten Zeitpunkt ergibt den Energiefluss zu diesem Zeitpunkt. Die Richtung des Stromes legt die Richtung des Energieflusses fest.

In einer Ausführungsform ist vorgesehen, dass die zumindest eine Energiequelle, beispielsweise eine Photovoltaikanlage oder ein Versorgungsnetz, elektrische Energie in Abhängigkeit des zumindest einen Parameters in den Energiespeicher speist. Wie oben ausgeführt, kann der zumindest eine Parameter beispielsweise ein Ladezustand oder eine momentan mindestens verfügbare Lade- oder Entladekapazität des Energiespeichers sein. Wenn beispielsweise ausreichend Ladekapazität zur Verfügung steht, kann die Energiequelle elektrische Energie in den Energiespeicher laden. Es können auch mehrere Energiequellen vorhanden sein.

Vorzugsweise ist die zumindest eine Energiequelle ein elektrisches Versorgungsnetz, insbesondere ein Wechselstromnetz, oder eine Photovoltaikanlage.

Um den Energiespeicher noch umfassender zu analysieren, kann auch ein Energiefluss in die oder aus der zumindest einen Energiequelle gemessen und beispielsweise zur Bestimmung des zumindest einen Parameters des Energiespeichers herangezogen werden. Die Messung an der Energiequelle kann durch eine weitere Messeinheit, beispielsweise ein Smart Meter, erfolgen. Insbesondere kann vorgesehen sein, dass der Energiefluss an einem Einspeisepunkt der Energiequelle, insbesondere an einem Einspeisepunkt des Versorgungsnetzes oder der Photovoltaikanlage, gemessen wird. Wenn mehrere Energiequellen vorhanden sind, kann vorgesehen sein, dass der Energiefluss in sämtliche oder aus sämtlichen Energiequellen gemessen wird. Bei dieser Ausführungsform kann beispielsweise festgestellt werden, unter welchen Bedingungen der Energiespeicher aktiv wird und dabei Energie aufnimmt oder abgibt. Eine mögliche Bedingung, unter welcher der Energiespeicher Energie aufnimmt, kann beispielsweise vorliegen, wenn am Einspeisepunkt bzw. an den Einspeisepunkten der Energiequelle/n eine Überschussenergie bzw. Überschussleistung vorhanden ist, die vom Energiespeicher aufgenommen wird. Es wird also der Zeitpunkt, zu dem alle bekannten Komponenten des Systems versorgt sind und überschüssige Energie zum Einspeisen ins Netz vorhanden ist, erkannt. Wird diese Überschussenergie nun von der weiteren Messeinheit gemessen, ist der Energiespeicher ab diesem Zeitpunkt aktiv und nimmt die Überschussenergie auf. Die Kenntnis über die Bedingungen, unter welchen der Energiespeicher aktiv wird, ermöglicht oder erleichtert in weiterer Folge die Steuerung des Energiespeichers.

Die eingangs erwähnte Aufgabe wird weiters durch ein elektrisches System zur Analyse eines elektrischen Energiespeichers nach Anspruch 10 gelöst, wobei das Analysesystem aufweist:
zumindest eine Messeinheit, insbesondere ein Smart Meter, zur Erfassung eines Energieflusses in einen oder aus einem elektrischen Energiespeicher, insbesondere einem Akkumulator oder einer Batterie;
eine Auswerteeinheit, welche dazu eingerichtet ist, iterativ auf Basis erfasster Werte des gemessenen Energieflusses zumindest einen Parameter des Energiespeichers zu bestimmen.

Das Analysesystem ist dazu eingerichtet, das oben beschriebene Verfahren auszuführen, wenn es in ein elektrisches Energieversorgungssystem mit einem elektrischen Energiespeicher eingebunden ist. Hinsichtlich der Vorteile und Funktionsweise des Analysesystems wird auf die obigen Ausführungen zum erfindungsgemäßen Verfahren verwiesen. Sämtliche Merkmale des Verfahrens sind auch auf das Analysesystem in entsprechender Weise übertragbar. Bei dem Analysesystem kann es sich um ein verteiltes System handeln. Die zumindest eine Messeinheit und die Auswerteeinheit können somit örtlich getrennt sein und beispielsweise über einen Server miteinander kommunizieren. Zwischen der zumindest einen Messeinheit und Auswerteeinheit kann jedenfalls ein Datenaustausch stattfinden. Die zumindest eine Messeinheit kann Messsensoren zum Erfassen von Strom und Spannung aufweisen. Die zumindest eine Messeinheit ist dazu eingerichtet, direkt oder indirekt den Energiefluss in den oder aus dem Energiespeicher zu erfassen.

Die Erfindung betrifft ein elektrisches Energieversorgungssystem, das folgendes aufweist:
- zumindest einen elektrischen Verbraucher;
- zumindest eine elektrische Energiequelle;
- zumindest einen elektrischen Energiespeicher; und
- ein elektrisches Analysesystem der oben beschriebenen Art, wobei der elektrische Verbraucher, die Energiequelle, der Energiespeicher und die zumindest eine Messeinheit des Analysesystems elektrisch miteinander verbunden sind.

Im Folgenden wird die Erfindung an Hand von Figuren näher erläutert, auf die sie allerdings nicht eingeschränkt sein soll. Darin zeigen:
- Fig. 1A und Fig. 1B: jeweils schematisch ein elektrisches Energieversorgungssystem mit einem elektrischen Energiespeicher;
- Fig. 2: einen schematischen zeitlichen Verlauf der im Energiespeicher enthaltenen Energie; und
- Fig. 3: ein Ablaufdiagramm des erfindungsgemäßen Verfahrens.

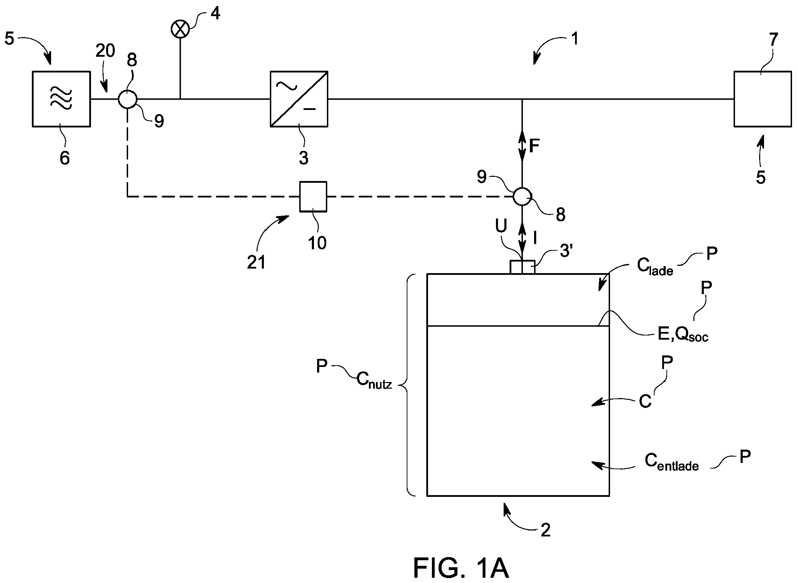

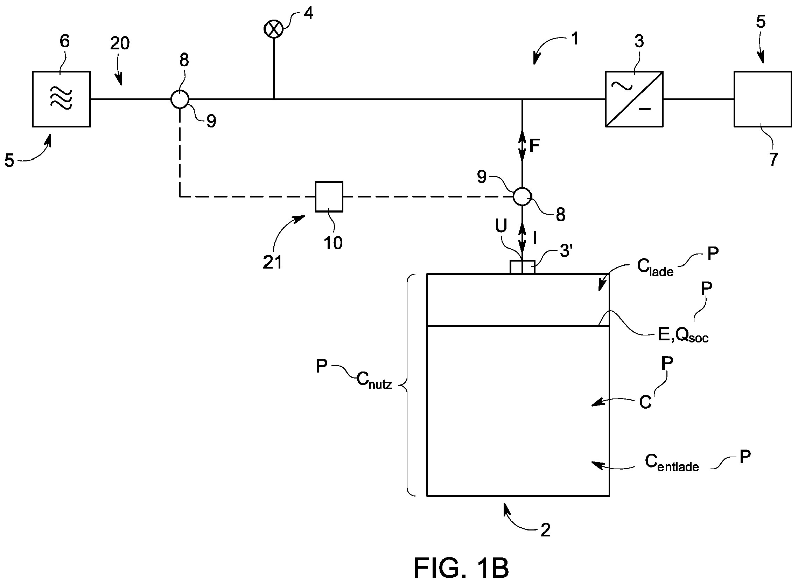

Fig. 1A und Fig. 1B zeigen beispielhaft unterschiedliche Varianten eines Energieversorgungssystems 1 mit einem elektrischen Energiespeicher 2, einem Wechselrichter 3, einem Verbraucher 4, einer ersten Energiequelle 5 in Form eines dreiphasigen Wechselstromnetzes 6 und einer zweiten Energiequelle 5 in Form einer Photovoltaikanlage 7, welche elektrisch entsprechend miteinander verbunden sind. Der Energiespeicher 2 kann innerhalb seines Gehäuses beispielsweise eine Steuerung, ein Managementsystem und eine Wandlereinheit 3' aufweisen.

Mit Hilfe zumindest einer Messeinheit 8, insbesondere einem Smart Meter 9, kann direkt oder indirekt ein elektrischer Energiefluss F in den oder aus dem elektrischen Energiespeicher 2 gemessen werden. Zu diesem Zweck werden von der zumindest einen Messeinheit 8 eine Spannung U und/oder ein Strom I gemessen. Daraus kann dann die elektrische Leistung bzw. der Energiefluss F in den oder aus dem Energiespeicher 2 bestimmt werden. Gegebenenfalls kann auch nur der Strom I gemessen werden, falls die Spannung U als konstant angenommen werden kann. Das Produkt der Spannung U und des Stromes I ergibt den Energiefluss F bzw. die Leistung oder eine hierfür repräsentative Größe, wobei die Richtung des Stromes I die Richtung des Energieflusses F vorgibt. Im gezeigten Ausführungsbeispiel sind zwei Messeinheiten 8 vorgesehen. Eine Messeinheit 8 ist in der Nähe des Energiespeichers 2 und eine weitere Messeinheit 8 an einem Einspeisepunkt 20 vorgesehen. Benötigt wird für das Verfahren jedoch nur zumindest eine Messeinheit 8, mit der der Energiefluss F in den oder aus dem Energiespeicher 2 bestimmt werden kann. Es können auch mehr als die dargestellten Messeinheiten 8 vorgesehen sein. Zwischen der Messeinheit 8 in der Nähe des Energiespeichers 2 und dem Energiespeicher 2 sind keine Verbraucher angeordnet. Die Messeinheit 8 in der Nähe des Energiespeichers 2 kann auch in den Energiespeicher 2 bzw. dessen Gehäuse integriert sein. Die gemessenen Werte des Energieflusses F können von den Messeinheiten 8 einer Auswerteeinheit 10, beispielsweise via Funk oder kabelgebunden, gegebenenfalls über einen Server, zur Verfügung gestellt werden. Die Auswerteeinheit 10 kann örtlich getrennt von den Messeinheiten 8 sein. Zumindest eine Messeinheit 8 und die Auswerteeinheit 10 bilden eine Minimalkonfiguration eines Analysesystems 21 zur Ausführung des erfindungsgemäßen Verfahrens.

Die gemessenen Werte der Messeinheit 8 am Einspeisepunkt 20 können genauso wie die gemessenen Werte, die durch die Messeinheit 8 in der Nähe des Energiespeichers 2 gemessen werden, an die Auswerteeinheit 10 übertragen und bei dem erfindungsgemäßen Verfahren berücksichtigt werden. Mit Hilfe der Messeinheit 8 am Einspeisepunkt 20 kann beispielsweise festgestellt werden, unter welchen Bedingungen am Einspeisepunkt 20 der Energiespeicher 2 aktiv wird, d.h. Energie E aufnimmt oder abgibt. Beispielsweise kann dies der Fall sein, wenn Überschussenergie am Einspeisepunkt 20 vorhanden ist. Mit diesen Kenntnissen kann das Energieversorgungssystem 1 effizienter gesteuert bzw. der Energiespeicher 2 in ein Energiemanagementkonzept eingebunden werden.

Fig. 1A und Fig. 1B zeigen jeweils unterschiedliche Varianten eines Energieversorgungssystems 1. In Fig. 1A ist der Energiespeicher 2 DC-seitig des Wechselrichters 3 angeschlossen. Dementsprechend wird der Energiespeicher 2 mit DC (engl. DC = "Direct Current") geladen bzw. entladen. Um unterschiedliche Spannungsniveaus auszugleichen, ist bevorzugt im Energiespeicher 2 bzw. in dessen Gehäuse eine Wandlereinheit 3', beispielsweise ein bidirektionaler DC/DC-Converter, integriert.

Fig. 1B zeigt eine alternative Konfiguration eines Energieversorgungssystems 1, wobei der Energiespeicher 2 AC-seitig des Wechselrichters 3 angeschlossen ist (engl. AC = "Alternating Current"). Im Folgenden wird nur auf die Unterschiede zu der Verschaltung aus Fig. 1A eingegangen. Im Energiespeicher 2 bzw. dessen Gehäuse kann eine Wandlereinheit 3' in Form eines Wechselrichters bzw. Inverters integriert sein, um den Energiespeicher 2 mit Gleichstrom zu laden oder entladen. Die Messeinheit 8 vor dem Energiespeicher 2 kann entfallen, wenn die Wandlereinheit 3' eine Schnittstelle zur Verfügung stellt, welche die Messwerte von Spannung U und Strom I zur Verfügung stellt.

Um die Lastflüsse in und aus dem Energiespeicher 2 zu steuern bzw. den Energiespeicher 2 bestmöglich in ein Energiemanagement einbinden zu können, sind Kenntnisse über dessen Betriebszustand notwendig. In der Regel werden Parameter P des Energiespeichers 2, wie eine Nutzkapazität C_{nutz} oder ein Ladezustand Qsoc, durch den Energiespeicher 2 über eine Datenschnittstelle zur Verfügung gestellt. Ein Datenaustausch ist jedoch meist nur zwischen Komponenten gleicher Hersteller möglich. Wenn jedoch der Energiespeicher 2 von einem anderen Hersteller als die übrigen Komponenten des Energieversorgungssystems 1 stammt, dann können die Parameter P des Energiespeichers 2 nur schwer oder gar nicht ausgelesen werden. Um den Betriebszustand eines Energiespeichers 2 eines fremden Herstellers eruieren zu können, ist erfindungsgemäß vorgesehen, dass der Energiefluss F in den oder aus dem Energiespeicher 2 gemessen wird und iterativ auf Basis erfasster Werte des gemessenen Energieflusses F zumindest ein Parameter P des Energiespeichers 2 bestimmt wird. Iterativ bedeutet, dass der zumindest eine Parameter P laufend neu bestimmt oder angepasst wird, und zwar auf Basis bisher erfasster und neu gemessener Werte des Energieflusses F. Es können auch mehrere Parameter P bestimmt werden. Beispiele für Parameter P sind der Ladezustand Q_{SOC}, eine Nutzkapazität C_{nutz} oder eine mindestens verfügbare Kapazität C des Energiespeichers 2. Die mindestens verfügbare Kapazität C kann eine momentan mindestens zur Verfügung stehende Ladekapazität C_{lade} oder eine momentan mindestens zur Verfügung stehende Entladekapazität C_{entlade} sein. In Fig. 1A und Fig. 1B wird aus Gründen der Übersicht nur C_{entlade} als mindestens verfügbare Kapazität C dargestellt. Aber auch C_{lade} bildet eine mindestens verfügbare Kapazität C. Die Summe aus der momentan mindestens zur Verfügung stehenden Ladekapazität C_{lade} und der momentan mindestens zur Verfügung stehenden Entladekapazität C_{entlade} ergibt die Nutzkapazität C_{nutz}. Eine Entladekapazität C_{entlade} bezeichnet eine Energiemenge, die dem Energiespeicher 2 entnommen werden kann. Eine Ladekapazität C_{lade} bezeichnet eine Energiemenge, die in den Energiespeicher 2 geladen werden kann. Im Folgenden wird beschrieben, wie die Parameter P des Energiespeichers 2 bestimmt werden können.

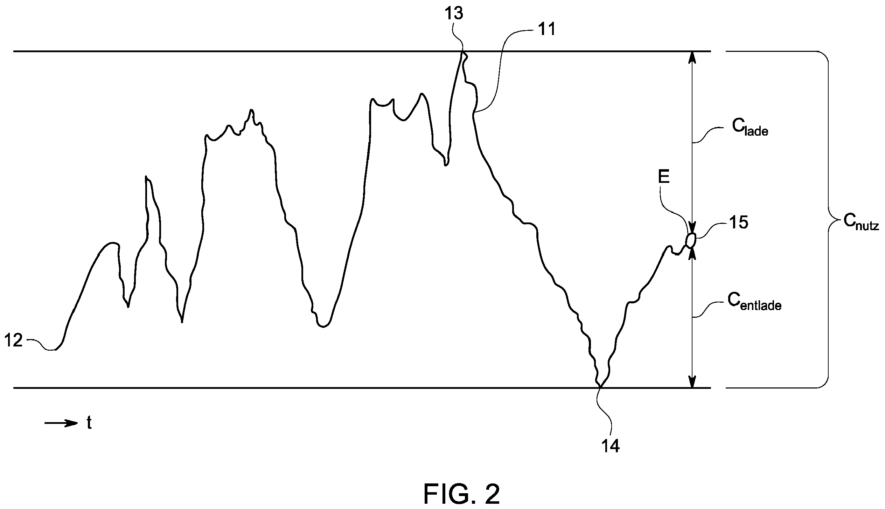

Aus den gemessenen Werten des Energieflusses F kann durch zeitliche Integration ein zeitlicher Verlauf der in den Energiespeicher 2 fließenden und aus dem Energiespeicher 2 entnommenen Energie E ermittelt werden. Der Verlauf der Energie E kann auch als zeitlicher Energieverlauf 11 bezeichnet werden. Der Energieverlauf 11 bildet die zu jedem Zeitpunkt im Energiespeicher 2 momentan enthaltene Energie E ab. Ein beispielhafter Energieverlauf 11 ist in Fig. 2 dargestellt. Es ist erkennbar, dass aus dem Energiespeicher 2 im Laufe der Zeit t Energie E entnommen und zugeführt wird. Die Messung des Energieflusses F erfolgt laufend und in zeitdiskreter Weise. Erkennt die Messung eine Aktivität (der Energiespeicher 2 ist also aktiv) im Energiefluss F, beginnt zu einem Startzeitpunkt 12 die Aufzeichnung bzw. Übermittlung der Daten an die Auswerteeinheit 10. Anschließend wird, beispielsweise im Rahmen einer anfänglichen Lernphase, der Energiefluss F gemessen und aufgezeichnet. Durch weitere Messungen des Energieflusses F kann der Energieverlauf 11 fortgesetzt werden. Auf Basis des Energieflusses F bzw. aus dem Energieverlauf 11 können folgende Parameter P bestimmt werden:
Aus dem globalen Maximum 13 und dem globalen Minimum 14 des Energieverlaufs 11 kann durch Differenzbildung eine aktuelle Nutzkapazität C_{nutz} des Energiespeichers 2 bestimmt werden. Durch Messungen des Energieflusses F über einen längeren Zeitraum kann die aktuelle Nutzkapazität C_{nutz} der tatsächlichen Nutzkapazität des Energiespeichers 2 angenähert werden.

In Fig. 2 ist nur ein Ausschnitt eines Energieverlaufs 11 dargestellt. Durch die Erfassung weiterer Messwerte des Energieflusses F kann der Energieverlauf 11 wie bereits erwähnt fortgesetzt werden. Dabei kann auch unter Umständen ein neues globales Maximum 13 bzw. globales Minimum 14 des Energieverlaufs 11 auftreten. Durch die erfindungsgemäße iterative Bestimmung der Parameter P wird eine allfällige Änderung des globalen Maximums 13 bzw. des globalen Minimums 14 erfasst und die aktuelle Nutzkapazität C_{nutz} angepasst bzw. neu bestimmt.

Der Energieverlauf 11 stellt die zu jedem Zeitpunkt im Energiespeicher 2 enthaltene Energie E dar. Um die momentan, d.h. zum aktuellen Endpunkt 15, im Energiespeicher 2 enthaltene Energie E zu bestimmen, können der Endpunkt 15 und das globale Minimum 14 des Energieverlaufs 11 herangezogen werden.

Aus dem Energieverlauf 11 kann auch eine mindestens verfügbare Kapazität C bestimmt werden. Die mindestens verfügbare Kapazität C kann eine momentan mindestens zur Verfügung stehende Ladekapazität C_{lade} oder eine momentan mindestens zur Verfügung stehende Entladekapazität C_{entlade} sein. Durch Ermittlung einer Differenz zwischen der momentan im Energiespeicher 2 enthaltenen Energie E und dem globalen Minimum 14 kann die momentan mindestens verfügbare Entladekapazität C_{entlade} des Energiespeichers 2 bestimmt werden. Die mindestens verfügbare Entladekapazität C_{entlade} ist eine Energiemenge, die dem Energiespeicher 2 mindestens entnommen werden kann. Die mindestens verfügbare Entladekapazität C_{entlade} kann der Energie E entsprechen. Wenn allerdings nicht die gesamte Energie E dem Energiespeicher 2 entnommen werden kann oder soll, können die Energie E und die mindestens verfügbare Entladekapazität C_{entlade} voneinander abweichen. Durch Ermittlung einer Differenz zwischen der momentan im Energiespeicher 2 enthaltenen Energie E und dem globalen Maximum 13 kann eine momentan mindestens verfügbare Ladekapazität C_{lade} des Energiespeichers 2 bestimmt werden. Die mindestens verfügbare Ladekapazität C_{lade} ist eine Energiemenge, die in den Energiespeicher 2 geladen werden kann.

Auf Basis der momentan im Energiespeicher 2 enthaltene Energie E und der Nutzkapazität C_{nutz} des Energiespeichers 2 kann zu jedem Zeitpunkt t ein momentaner Ladezustand Q_{SOC} des Energiespeichers 2 als Parameter bestimmt werden. Zur Bestimmung des momentanen Ladezustands Q_{SOC} kann ein Verhältnis der momentan im Energiespeicher 2 enthaltenen Energie E zur Nutzkapazität C_{nutz} gebildet werden und dieses Verhältnis beispielsweise in Prozent ausgedrückt werden.

In der Nutzkapazität C_{nutz} des Energiespeichers 2 kann auch eine Energiereserve für einen Notstrombetrieb enthalten sein. Anders ausgedrückt ist die Energiereserve ein Teil der mindestens verfügbaren Entladekapazität C_{entlade}, der im Notstrombetrieb genutzt werden kann.

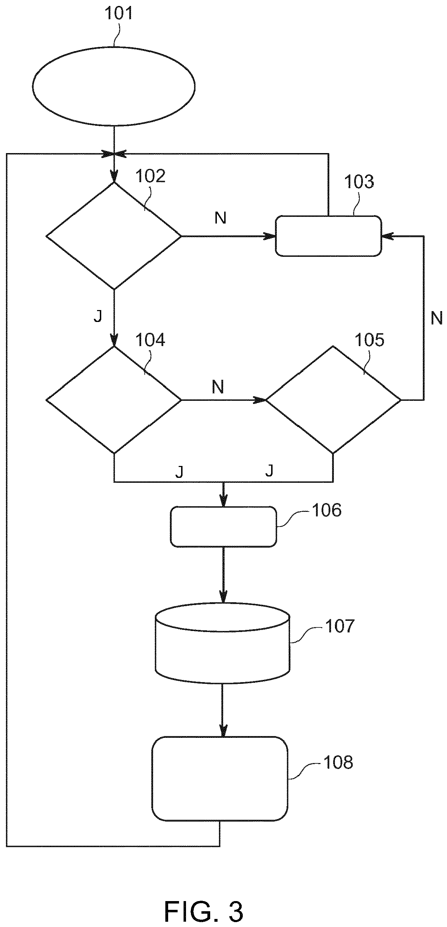

In Fig. 3 ist ein beispielhaftes Ablaufdiagramm für das gegenständliche Verfahren gezeigt, welches in der Auswerteeinheit 10 ausgeführt wird. Der zumindest eine Parameter P des Energiespeichers wird durch Ausführung der Schritte 101 bis 108 bestimmt. Die Schritte 101 bis 108 werden iterativ ausgeführt. In Schritt 101 wird der Ablauf gestartet. Durch ständige Ermittlung des Energieflusses F werden Messwerte zur Verfügung gestellt. In Schritt 102 wird anhand der Messwerte festgestellt, ob der Energiespeicher 2 geladen oder entladen wird und damit aktiv ist. Bei inaktivem Energiespeicher 2 wird zunächst gewartet (Schritt 103), bis der Energiespeicher 2 aktiv ist. Bei aktivem Energiespeicher 2 wird in Schritt 104 festgestellt, ob der Energiespeicher 2 geladen wird. Falls dem nicht so ist, wird festgestellt, ob der Energiespeicher 2 entladen wird (Schritt 105). Wenn der Energiespeicher 2 geladen oder entladen wird, wird der gemessene Energiefluss F in Schritt 106 aufgezeichnet und zusammen mit einem Zeitstempel zyklisch gespeichert (repräsentiert durch Block 107, der einen Datenspeicher darstellt). In Schritt 108 wird der zumindest eine Parameter P des Energiespeichers 2 wie oben beschrieben bestimmt. Der Ablauf beginnt anschließend wieder von vorne bei Schritt 101, um den zumindest einen Parameter P des Energiespeichers 2 aktuell zu halten. Aufgrund dieses gespeicherten Energieflusses kann beispielsweise eine Darstellung gemäß Fig. 2 produziert werden.

Vorzugsweise werden nur Messwerte des Energieflusses gespeichert bzw. zur Bestimmung des zumindest einen Parameters herangezogen, wenn der Energiespeicher 2 aktiv ist. Dadurch gibt es in der Auswertung bzw. in der Darstellung (vgl. Fig. 2) keine oder nur kurze konstante Linien der Energie E, sodass eine aussagekräftige Darstellung mit steigenden und fallenden Linien resultiert. Es kann auch ein Energiefluss F einer oder mehrere Energiequellen 5 berücksichtigt werden.

## Patentansprüche

1. Verfahren zur Analyse eines elektrischen Energiespeichers (2), insbesondere eines Akkumulators oder einer Batterie, wobei der Energiespeicher (2) in einem elektrischen Energieversorgungssystem (1) mit zumindest einem Verbraucher (4) und zumindest einer elektrischen Energiequelle (5) elektrisch verbunden ist, **dadurch gekennzeichnet, dass** ein elektrischer Energiefluss (F) in den oder aus dem Energiespeicher (2) gemessen wird und iterativ auf Basis erfasster Werte des gemessenen Energieflusses (F) zumindest ein Parameter (P) des Energiespeichers (2) bestimmt wird.

2. Verfahren nach Anspruch 1, **dadurch gekennzeichnet, dass** auf Basis erfasster Werte des Energieflusses (F) eine Nutzkapazität (C_{nutz}) des Energiespeichers (2) als Parameter (P) bestimmt wird.

3. Verfahren nach Anspruch 1 oder 2, **dadurch gekennzeichnet, dass** auf Basis erfasster Werte des Energieflusses (F) eine momentan in dem Energiespeicher (2) enthaltene Energie (E) als Parameter (P) bestimmt wird.

4. Verfahren nach Anspruch 3 in Rückbeziehung auf Anspruch 2, **dadurch gekennzeichnet, dass** auf Basis der momentan in dem Energiespeicher (2) enthaltenen Energie (E) und der Nutzkapazität (C_{nutz}) des Energiespeichers (2) ein momentaner Ladezustand (Q_{SOC}) des Energiespeichers (2) als Parameter (P) bestimmt wird.

5. Verfahren nach einem der Ansprüche 1 bis 4, **dadurch gekennzeichnet, dass** auf Basis erfasster Werte des Energieflusses (F) eine momentan mindestens verfügbare Kapazität (C), insbesondere eine mindestens verfügbare Ladekapazität (C_{lade}) oder eine mindestens verfügbare Entladekapazität (C_{entlade}), des Energiespeichers (2) als Parameter (P) bestimmt wird.

6. Verfahren nach einem der Ansprüche 1 bis 5, **dadurch gekennzeichnet, dass** zur Messung des Energieflusses (F) in oder aus dem Energiespeicher (2) ein elektrischer Strom (I) in und aus dem Energiespeicher (2) sowie eine elektrische Spannung (U) am Energiespeicher (2) gemessen wird.

7. Verfahren nach einem der Ansprüche 1 bis 6, **dadurch gekennzeichnet, dass** die zumindest eine Energiequelle (5) elektrische Energie in Abhängigkeit des zumindest einen Parameters (P) in den Energiespeicher (1) speist.

8. Verfahren nach einem der Ansprüche 1 bis 7, **dadurch gekennzeichnet, dass** die zumindest eine Energiequelle (5) ein elektrisches Versorgungsnetz (6), insbesondere ein Wechselstromnetz, oder eine Photovoltaikanlage (7) ist.

9. Verfahren nach einem der Ansprüche 1 bis 8, **dadurch gekennzeichnet, dass** auch ein Energiefluss (F) in die oder aus der zumindest einen Energiequelle (5) gemessen und beispielsweise zur Bestimmung des zumindest einen Parameters (P) des Energiespeichers (1) herangezogen wird.

10. Elektrisches System (21) zur Analyse eines elektrischen Energiespeichers (2), aufweisend:
zumindest eine Messeinheit (8), insbesondere ein Smart Meter (9), zur Erfassung eines Energieflusses (F) in einen oder aus einem elektrischen Energiespeicher (2), insbesondere einem Akkumulator oder einer Batterie;
eine Auswerteeinheit (10), welche dazu eingerichtet ist, iterativ auf Basis erfasster Werte des gemessenen Energieflusses (F) zumindest einen Parameter (P) des Energiespeichers (2) zu bestimmen.

11. Energieversorgungssystem (1), aufweisend:
zumindest einen elektrischen Verbraucher (4);
zumindest eine elektrische Energiequelle (5);
zumindest einen elektrischen Energiespeicher (2); und
ein elektrisches Analysesystem (21) nach Anspruch 10, wobei der elektrische Verbraucher (4), die Energiequelle (5), der Energiespeicher (2) und die zumindest eine Messeinheit (8) des Analysesystems (21) elektrisch miteinander verbunden sind und die Messeinheit (8) zur Erfassung des Energieflusses (F) in den und/oder aus dem Energiespeicher (2) eingerichtet ist.
